Europäisches Patentamt

European Patent Office

Office européen des brevets

(11) Veröffentlichungsnummer : **0 042 121**
**B1**

(12) **EUROPÄISCHE PATENTSCHRIFT**

(45) Veröffentlichungstag der Patentschrift :
26.09.84

(51) Int. Cl.³ : **G 11 B  5/09, H 04 L  1/10//**
**G06F11/10**

(21) Anmeldenummer : **81104356.1**

(22) Anmeldetag : **05.06.81**

(54) **System zur Verarbeitung und Übertragung von PCM Signalen.**

(30) Priorität : **16.06.80 DE 3022573**

(43) Veröffentlichungstag der Anmeldung :
**23.12.81 Patentblatt 81/51**

(45) Bekanntmachung des Hinweises auf die Patenterteilung : **26.09.84 Patentblatt 84/39**

(84) Benannte Vertragsstaaten :
**AT BE CH DE FR GB IT LI LU NL SE**

(56) Entgegenhaltungen :
**DE-A- 2 240 057**
**DE-A- 2 903 998**
**DE-A- 2 915 459**
**DE-A- 2 916 102**
**DE-A- 2 941 805**
**DE-A- 2 946 702**
**GB-A- 2 060 227**
**IEEE TRANSACTIONS ON COMMUNICATIONS TECHNOLOGY, Band COM-19, Heft 5, Oktober 1971, NEW YORK (US) G.D. FORNEY: "Burst-correcting Codes for the Classic Bursty Channel", Seiten 772-781**
**JOURNAL OF THE SOCIETY OF MOTION PICTURE AND TELEVISION ENGINEERS, Band 89, Heft 3, März 1980, SCRASDALE-NEW YORK (US) YOKOYAMA et al.: "An experimental digital videotape recorder", Seiten 173-180**

(73) Patentinhaber : **Licentia Patent-Verwaltungs-GmbH**
**Theodor-Stern-Kai 1**
**D-6000 Frankfurt/Main 70 (DE)**

(72) Erfinder : **Scholz, Werner, Dipl.-Ing.**
**Osterstrasse 20**
**D-3007 Gehrden (DE)**

(74) Vertreter : **Einsel, Robert, Dipl.-Ing.**
**Theodor-Stern-Kai 1**
**D-6000 Frankfurt/Main 70 (DE)**

Jouve, 18, rue St-Denis, 75001 Paris, France

**Beschreibung**

Die Erfindung betrifft ein System zur Verarbeitung und Übertragung von PCM Signalen, insbesondere von Tonsignalen, die im PCM-Format auf einem Speichermedium aufgezeichnet und von diesem wiedergegeben werden.

Es sind Verfahren bekannt, Ton- oder Fernsehsignale als pulscodemodulierte Signale auf einem Aufzeichnungsmedium, z. B. einem Magnetband oder eine Platte, aufzuzeichnen. Es ist zwar prinzipiell möglich, aufzuzeichnende oder zu übertragende Daten einer einfachen Pulscodemodulation zu unterziehen und diese codierten Daten zu übertragen bzw. aufzuzeichnen. Aber nur bei einem idealen Übertragungskanal wäre ein derartiges Modulationsverfahren ausreichend, um hohe Ansprüche an die Übertragungsqualität zu erfüllen.

Ein Magnetband, eine Platte oder eine Übertragungsstrecke sind in der Realität nicht ideal, sondern verfälschen das zu verarbeitende Signal. Eine Reproduzierbarkeit ist daher nur ungenügend gewährleistet. Die Übertragungsstrecke, das Band oder die Platte werden im folgenden als Kanal bezeichnet. Der Kanal ist ein störbehaftetes Medium, das die Signale im allgemeinen so verfälscht, daß eine Übertragung ohne eine Datensicherung nicht möglich ist. Es gibt verschiedene Möglichkeiten zur Datensicherung, die teilweise allein oder zusammen mit anderen angewendet werden.

Ein übliches Verfahren arbeitet folgendermaßen : Die zu übertragenden Daten werden seriell in Blöcke gleicher Anzahl von Datenwörtern aufgeteilt. Jeder Datenblock wird um ein sogenanntes CRC-Datenwort sowie einem Synchronisationswort ergänzt. Das CRC-Wort (cyclic redundancy check) ist ein zyklischer Code, der über eine Polynomdarstellung gewonnen wird. Auf diese Weise können Fehler des mit einem CRC-Datenwort abgeschlossenen blockes erkannt werden. Derartige CRC-Datenwortschaltungen sind als integrierte Schaltkreise handelsüblich (z. B. Fairchild 9401). Zur Fehlerkorrektur kann jedem Block noch ein sogenanntes Paritätswort angefügt werden, so daß zusammen mit dem CRC-Datenwort eine Erkennung und eine Korrektur fehlerbehafteter Daten ermöglicht ist.

Damit eine Korrektur durchgeführt werden kann, müssen zusammengehörende Daten- und paritätswörter in verschiedenen Blöcken übertragen werden, denn schon ein einziger Bitfehler macht einen vollständigen Block zunächst einmal unbrauchbar.

Es gibt daher Vorschläge, wie sie in der DE-OS 22 40 057 wiedergegeben sind, die gesamten Daten nicht in der ursprünglichen Reihenfolge über den Kanal zu geben, sondern die einzelnen Datenwörter abwechselnd um eine bestimmte Dauer oder um ein vielfaches davon zu verzögern und die verzögerten und unverzögerten Datenwörter nacheinander über den Kanal zu geben. Dies wird als Verschachtelung oder Interleaving bezeichnet. Bei Aufzeichnungsgeräten auftretende Störungen wirken vorzugsweise als sogenannte Burstfehler auf während der Übertragung aufeinanderfolgende Datenwörter bzw. Blöcke. Diese werden jedoch durch das Interleaving-Verfahren im Ergebnis wieder auseinandergezogen, so daß die Störung bei der endgültigen richtigen Zusammenfügung der Datenwörter in der ursprünglichen Reihenfolge gestreut wird. Die gestreuten Fehler können dann durch Paritätsvergleich oder über eine Interpolationsschaltung eliminiert werden. Eine derartige Verschachtelungsmethode ist in einem Bericht der Audio Engineering Society, 64. Konvention vom 2. November bis 5. November 1979 in New York City veröffentlicht. Eine solche Verschachtelungsmethode erlaubt es, Störstellen aus den Signalen größtenteils zu entfernen. Manche Störungen des Kanals verursachen jedoch in dem wiederzugebenen signal Fehlerstellen, die sich noch über mehrere benachbarte Datenwörter erstrecken können. In diesem Fall ist eine echte Korrektur durch Paritätsvergleich nicht möglich. Gleichzeitig sind aber auch die Voraussetzungen für die Korrektur durch Interpolation besonders ungünstig, da ungestörte Stützwerte zwischen den zu ersetzenden Werten fehlen.

Die Anmelderin weist auf die europäische Parallelummeldung Nr. 81 10 4357.9 hin, in der vorgeschlagen ist, aufeinanderfolgende Datenwörter eines PCM-Signals zyklisch verschachtelt mit ungleichen Verschachtelungsabständen über einen Kanal zu übertragen.

Aufgabenstellung :

Der Erfindung liegt die Aufgabe zugrunde, ein System zur Verarbeitung von PCM-Signalen anzugeben, bei dem für eine Interpolation mehr ungestörte Stützwerte zwischen den zu ersetzenden Werten erreicht werden als bei bekannten Einrichtungen.

Die Aufgabe wird durch die im Anspruch 1 angegebenen Maßnahmen gelöst. Weitergehende Ausbildungen der Erfindung sind in den Unteransprüchen beschrieben.

Die Erfindung ermöglicht gegenüber herkömmlichen Schaltungen eine verbesserte Fehlerverdeckung durch Interpolation, wenn durch das Auftreten von Doppelfehlern bei bestimmten Fehlerabständen eine Korrektur mit Hilfe des Paritätssignals nicht möglich ist. An Stellen hoher Fehlerdichte werden also die nicht durch Paritätsvergleich korrigierbare doppelfehler durch die erfindungsgemäße zusätzliche Verschachtelung noch einmal zerstreut, so daß eine gute Fehlerbeseitigung durch Interpolation ermöglicht wird.

An den Fehlerstellen, an denen auch eine Interpolation gut durchführbar ist, kann auch eine echte Korrektur durch Auswertung des Paritätswortes erfolgen, vorausgesetzt, daß das Paritätswort ohne Fehlermarkierung ist. Dort, wo zwei Werte innerhalb eines Abtasttripels eine Fehlermarkierung besitzen, ist keine echte Korrektur durchführbar. Gerade hier sind aber auch die Bedingungen für die Interpolation in den meisten Fällen besonders ungünstig. Bei einer Verschachtelung mit ungleichen Abständen kann bei zwei Fehlerstellen X und Y nur immer höchstens ein Doppelfehler auftreten. Jedoch ist dieser Doppelfehler weder echt korrigierbar noch für eine einwandfreie Interpolation geeignet. Durch die zusätzliche Verschachtelung wird dieser Mangel behoben. Die Verschachtelungsabstände d für die zusätzliche Verschachtelung können wesentlich kleiner gewählt werden als die Abstände D für die Hauptverschachtelung, sofern die Wahrscheinlichkeit für die unmittelbare Aufeinanderfolge zweier sehr langer Burstfehler sehr gering ist. Um mit wenig Speicheraufwand eine möglichst wirkungsvolle Verschachtelung zu erreichen, ist es zweckmäßig, die zusätzliche Verschachtelung so durchzuführen, daß sich zusammen mit der Hauptverschachtelung eine vergrößerte Gesamtverschachtelung ergibt.

Die Erfindung wird nachstehend an Hand eines Ausführungsbeispiels näher erläutert. Es zeigen :

Figur 1 einen prinzipiellen Aufbau einer PCM Aufnahmeeinrichtung,

Figur 2 einen prinzipiellen Aufbau einer PCM Wiedergabeeinrichtung,

Figur 3 eine bekannte Verschachtelungseinrichtung,

Figur 4 eine Darstellung zur Verdeutlichung der Wirkungsweise einer bekannten Verschachtelungseinrichtung,

Figur 5 ein Diagramm zur Darstellung der Ermittlung des Paritätswortes,

Figur 6 eine Darstellung einer bekannten Entschachtelungseinrichtung,

Figur 7 eine erfindungsgemäße Anordnung einer mehrfachen Verschachtelungseinrichtung,

Figur 8 eine erfindungsgemäße Anordnung einer mehrfachen Entschachtelungseinrichtung,

Figur 9 eine erfindungsgemäße Anordnung einer Verschachtelungseinrichtung mit gleichen Verschachtelungsabständen,

Figur 10 eine Anordnung einer Entschachtelungseinrichtung ohne Paritätsvergleich für das erfindungsgemäße Signal,

Figur 11 eine erfindungsgemäße Entschachtelungsanordnung mit Paritätsvergleich,

Figur 12 eine Darstellung der Wirkung von Fehlern bei einer bekannten Einrichtung gemäß Figuren 3 bis 6 mit gleichen Verschachtelungsabständen,

Figur 13 eine Darstellung der Wirkung von Fehlern bei einer bekannten Einrichtung mit ungleichen Verschachtelungsabständen und

Figur 14 eine Darstellung der Wirkung von Fehlern bei einer erfindungsgemäßen Einrichtung gemäß Figuren 9 und 11.

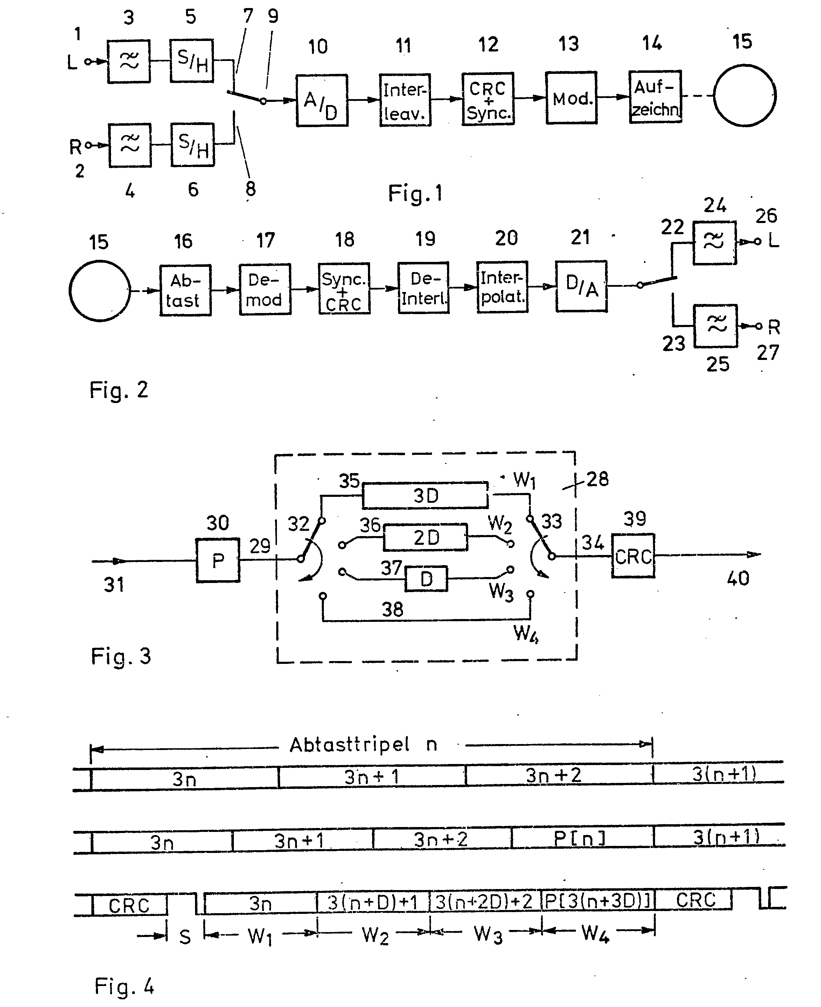

Das in Fig. 1 dargestellte Aufnahmesystem zeigt in vereinfachter Form, wie die Signale zweier Tonkanäle so verarbeitet werden können, daß sie über einen sogenannten Kanal gegeben werden können. Die Eingänge 1 und 2 stellen die niederfrequenten Eingänge der zwei Tonkanäle links und rechts dar. Wir beschränken uns hier auf die Betrachtung zweier Tonkanäle, obwohl es sich auch beispielsweise um die Übertragung von 4 voneinander unabhängigen NF-Kanälen handeln könnte. In jedem der beiden Verarbeitungskanäle liegt ein Antialiasingfilter 3 und 4. Das Antialiasingfilter verhindert die Verfälschung des Signals durch den Abtastvorgang. An die beiden Antialiasingfilter 3 und 4 schließen sich die Sample- and Hold-Schaltungen 5 und 6 an. Alle nachfolgenden Schaltkreise einschließlich der Sample- and Hold-Schaltungen 5 und 6 werden von einem gemeinsamen Taktgenerator gesteuert, der nicht dargestellt ist. Die beiden Ausgänge der im Gegentakt betriebenen Sample- and Hold-Schaltungen 5 und 6 werden an die zwei Klemmen 7 und 8 eines Umschalters 9 geführt, der immer gerade den Abtastwert durchschaltet, der gehalten wird, während im anderen Kanal die Abtastung erfolgt. Durch diesen Umschalter 9 wird erreicht, daß die jeweiligen Abtastwerte der Kanäle links und rechts in serieller reihenfolge abwechselnd dem nachfolgenden Analog/Digital-Wandler 10 zugeführt werden. Dem Analog/Digital-Wandler ist die sogenannte Interleaving-Schaltung 11 nachgeschaltet, in der die in richtiger Reihenfolge ankommenden Datenwörter verschachtelt werden. Die verschachtelten Datenwörter werden in Gruppen von z. B. je drei Abtastwertepaaren zusammengefaßt. In einer weiteren Schaltung 12 werden jeder Gruppe ein CRC-Wort und Synchronisationsbits zugefügt. Dieses blockweise codierte Digitalsignal wird auf einen Modulator 13 geführt, von dem das modulierte Signal auf den Übertragungs-Kanal gegeben wird, der hier z. B. aus einem Aufzeichnungsgerät 14, dem Aufzeichnungsträger 15 und einer Abtasteinrichtung 16 besteht. Dabei kann der Aufzeichnungsträger 15 ein Magnetband oder eine Platte sein. Der Übertragungskanal 14, 15, 16 kann aber auch durch ein Kabel oder eine Funkstrecke gebildet werden.

Fig. 2 zeigt eine Wiedergabeeinrichtung zur Verarbeitung eines von einem Aufzeichnungsträger 15 abgetasteten PCM-Signals. Das von einer Abtasteinrichtung 16 gewonnene Signal wird einem Demodulator 17 zugeführt. Vom Demodulator 17 gelangt das PCM-Signal auf eine Schaltung 18, in der Synchronisations- und CRC-Wörter ausgewertet werden. Ergibt die CRC-Auswertung eine Fehlermeldung, so werden sämtliche Datenwörter des betreffenden Blocks mit einer Fehlermarkierung versehen. Es folgt die Deinterleavingschaltung 19, die die auf der Aufnahmeseite verschachtelten Datenwörter entschachtelt. Mit Fehlermarkierung versehene Datenwörter werden anschließend in der Interpolationsschaltung 20 durch den mittelwert aus den benachbarten Datenwörtern ersetzt. Das jetzt entstandene korrigierte und in richtiger Reihenfolge seriell vorliegende PCM-Datensignal wird auf den Digital/Analog-Wandler 21 gegeben, von dem es abwechselnd auf die beiden Niederfrequenzkanäle 22 und 23 mit den Tiefpaßfiltern 24 und 25 gegeben wird. An den Klemmen 26 und 27 ist dann das niederfrequente Signal zur weiteren Verarbeitung abgreifbar. Die Interpolation kann auch im analogen Bereich, d. h. hinter dem Digital/Analog-Wandler erfolgen.

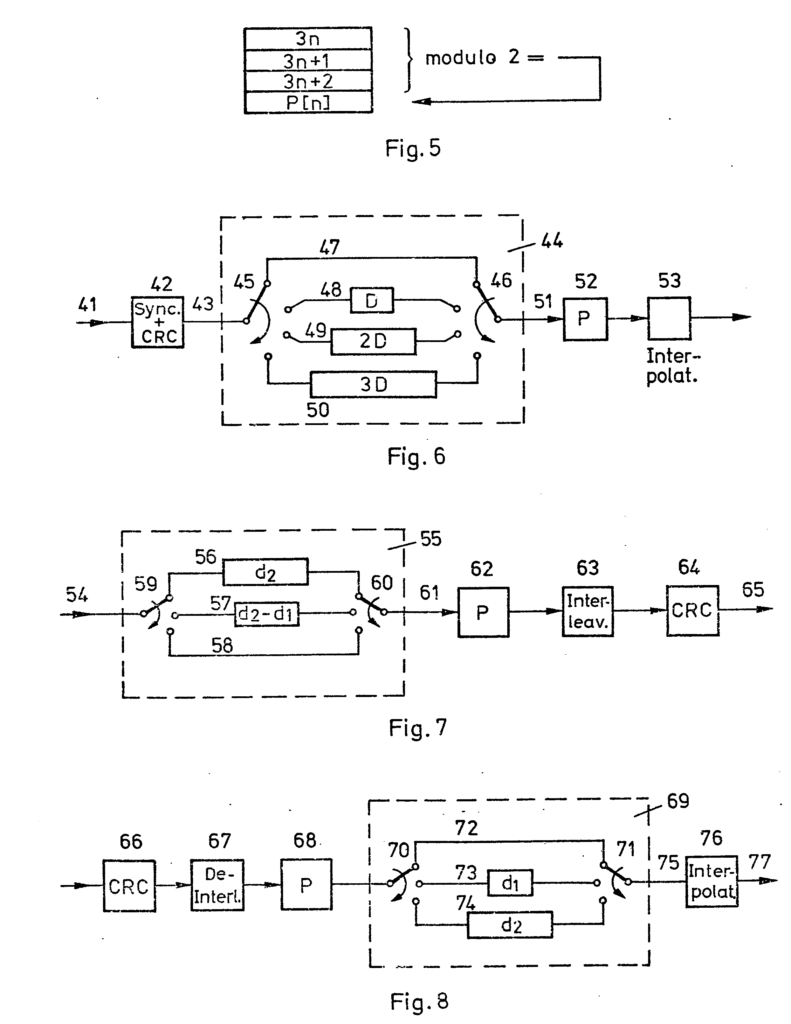

Um eine echte Korrektur von gestörten Abstastwerten zu ermöglichen, muß z. B. ein zusätzliches Paritätssignal übertragen werden. Zur Erzeugung des Paritätssignals wird in die Schaltung (Fig. 1) zwischen Analog/Digital-Wandler 10 und Interleavingschaltung 11 ein zusätzlicher Schaltungsteil 30 (Fig. 3) eingefügt. Zur Auswertung des Paritätssignal dient der zusätzliche Schaltungsteil 52 (Fig. 6), der in der Gesamtschaltung (Fig. 2) zwischen der Deinterleavingschaltung 19 und dem Interpolator 20 angeordnet ist.

Fig. 3 zeigt eine bekannte Verschachtelungseinrichtung, die eine Interleavingschaltung 28 enthält, die an den Ausgang 29 einer Paritätsschaltung 30 angeschlossen ist. Das Signal, das vom Analog/Digital-Wandler 10 an den Eingang 31 der Paritätsschaltung 30 gelangt, wird blockweise um ein Paritätswort ergänzt, das neben den Signalworten gleichfalls in der Interleavingschaltung 28 verarbeitet wird. Die Interleavingschaltung 28 enthält zwei Umschalter 32 und 33, die synchron Eingang 29 und Ausgang 34 nacheinander mit den Strecken 35 bis 38 verbinden. Dabei enthält die Strecke 35 eine Einrichtung zur Verzögerung des ankommenden Signals um eine Dauer 3D. Das ist die Dauer von 3D aufeinanderfolgenden Datenblöcken mit z. B. D = 16. Die Strecke 36 enthält eine Verzögerung um die Dauer 2D, die Strecke 37 eine Verzögerung um die Dauer D und die Strecke 38 enthält keine Verzögerung. An den Ausgang 34 der Interleavingschaltung 28 ist ein Schaltkreis 39 angeschlossen, der den verschachtelten Datenwörtern ein Prüfwort und Synchronisationsbits anhängt. Vom Schaltkreis 39 gelangt das Signal über die Leitung 40 an den Modulator 13.

In Fig. 4 ist dargestellt, wie das an den Modulator 13 gelangende Signal gebildet wurde. Das am Eingang 31 der Paritätsschaltung 30 anliegende Signal ist in Fig. 4, erste Zeile dargestellt. Das Abtasttripel mit der Numerierung n enthält die Abtastwertepaare 3n, 3n + 1 und 3n + 2. Jedem Abtasttripel n wird in der Paritätsschaltung 30 entsprechend.

Fig. 4, zweite Zeile das Paritätswort P(n) angehängt. Jedes Abtastwertepaar eines Abtasttripels n besteht aus einem Wort von 28 Bit. Fig. 4, dritte Zeile, zeigt das Signal, das am Eingang 40 der Modulatorschaltung anliegt. Die einzelnen Datenwörter sind durch die Interleavingschaltung 28 derart verschachtelt worden, daß alle Abtastworte außer mit der Numerierung 3n mehr oder weniger verzögert wurden. Das Abtastwort P(n) ist z. B. um 3D verzögert worden. Den vier Abtastworten $w_1$ bis $w_4$ werden in der Schaltung 39 (entsprechend 12 in Fig. 1) ein CRC-Wort und Synchronisationsbits angehängt.

Fig. 5 zeigt die Bildung des Paritätswortes eines Abtasttripels mit der Blocknumerierung n. Dieses wird bitweise durch modulo-2-addition der einzelnen Abtastworte erzeugt. Das Paritätswort wird in gleicher Weise behandelt wie die Abtastwörter, und daher in der Interleavingschaltung 28 ebenfalls einer Verzögerung unterworfen.

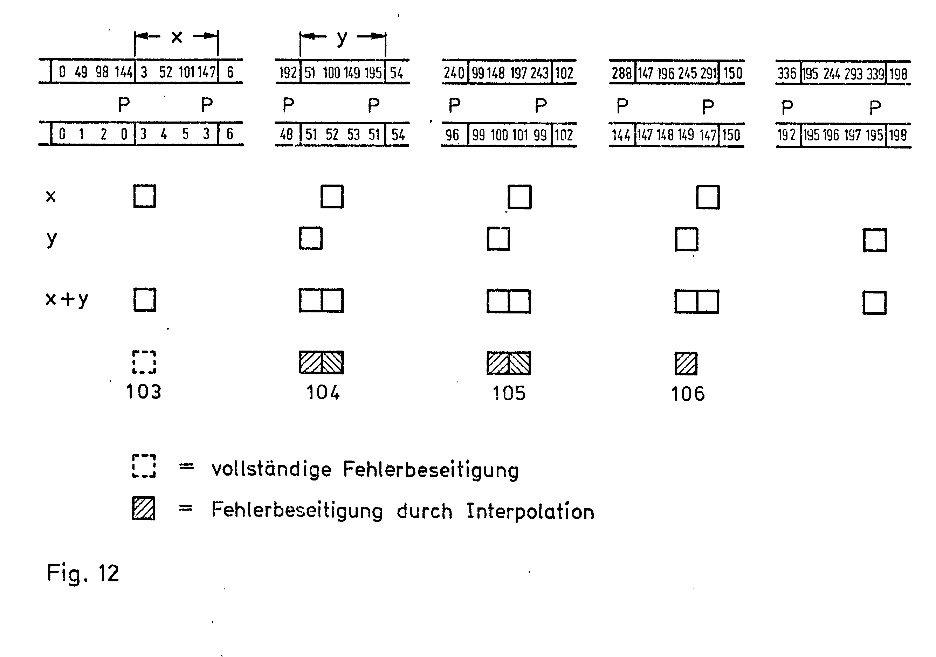

Fig. 6 zeigt eine Entschachtelungseinrichtung, die entsprechend Fig. 3, aber in umgekehrter Ordnung aufgebaut ist. Vom Demodulator 41 gelangt das Signal über einen CRC-Schaltkreis 42, in den geprüft wird, ob der betreffende Block richtig übertragen wurde. Ergibt die CRC-Auswertung eine Fehlermeldung, so werden sämtliche Datenwörter des betreffenden Datenblocks mit einer Fehlermarkierung versehen. Vom Ausgang 43 der Schaltung 42 gelangt der von Synchronisationsbits und CRC-Wörtern befreite Datenblock an die Deinterleavingschaltung 44, in der das Signal zyklisch nacheinander durch die synchron arbeitenden Schalter 45 und 46 auf die Strecken 47 bis 50 gegeben wird. Die Strecke 47 enthält dabei keine Verzögerung, die Strecke 48 eine Verzögerung um die Dauer D, die Strecke 49 eine Verzögerung um die Dauer 2D und die Strecke 50 eine Verzögerung um die Dauer 3D. Vom Ausgang 51 der Deinterleavingschaltung 44 gelangt das Signal auf die Paritätsschaltung 52, in der das Paritätswort ausgewertet wird, und eine Korrektur fehlerhafter Worte vorgenommen wird. Von der Paritätsschaltung 52 gelangt das Signal zu einer Interpolationsschaltung 53, in der Fehlerstellen, die nicht durch Paritätsvergleich korrigiert werden konnten, weil innerhalb eines Vergleichsblocks (Fig. 5) mehrere Fehlermarkierungen auftraten, mit vor- und nachfolgenden Datenwörtern so verknüpft werden, daß annähernd das richtige Datenwort erreicht ist (Fig. 12).

Fig. 7 zeigt eine erfindungsgemäße Anordnung einer mehrfachen Verschachtelungseinrichtung. Hierbei gelangt das Signal, das vom Analog/Digital-Wandler kommt, auf den Eingang 54 einer Interleavingschaltung 55, in der ankommende Datenwörter abwechselnd über die Verzögerungsstrecken 56, 57 oder 58 gegeben werden. Die Differenzen zwischen den Verzögerungsstrecken 56 und 57 und 58 können zunächst einmal beliebig sein. Die Umschalter 59 und 60 schalten dabei synchron Eingang 54 und Ausgang 61 an die Verzögerungsstrecken 56 mit der Verzögerungsdauer $d_2$, die Verzögerungsstrecke 57 mit der Verzögerungsdauer $d_2-d_1$ und die Strecke 58 ohne Verzögerungsdauer. Vom Ausgang 61 der Interleavingschaltung 55 werden die verschachtelten Datenwörter auf die Paritätsschaltung 62 gegeben, in der ein Paritätswort durch modulo-2-Addition von mehreren aufeinanderfolgenden Datenwörtern, die durch die Interleavingschaltung verschachtelt wurden, gebildet. Das Ausgangssignal der Paritätsschaltung 62 gelangt nun auf eine weitere Interleavingschaltung 63, die die ankommenden Datenwörter noch einmal mit gleichen oder ungleichen Verschachtelungsabständen verschachtelt. In den mehrfach verschachtelten Datenwörtern werden in dem folgenden Schaltkreis 64 noch Synchronisationsbits und ein CRC-Wort angehängt. Dieses Signal gelangt dann über die Leitung 65 zum Modulator 13 (Fig. 1).

Die in Fig. 8 dargestellte der Fig. 7 komplementäre Schaltung auf der Wiedergabeseite zeigt, wie die vom Kanal ankommenden Signale so verarbeitet werden können, daß sie den niederfrequenten Kanälen zugeführt werden können. Vom Kanal gelangen die Signale zu einem CRC-Schaltkreis 66, in dem die CRC-Wörter geprüft werden. Wird ein Fehler festgestellt, so werden alle zu einem Block gehörenden Datenwörter mit einem Fehlersignal gekennzeichnet. An den CRC-Schaltkreis 66 schließt sich die Deinterleavingschaltung 67 an, die das ankommende Signal komplementär zur Interleavingschaltung im Schaltkreis 63 von Fig. 7 entschachtelt. Vom Deinterleavingschaltkreis 67 gelangen die einmal entschachtelten Datenwörter auf den Paritätsschaltkreis 68, in dem das Paritätswort von den übrigen Daten abgetrennt wird und ausgewertet wird. Das paritätskorrigierte Signal gelangt dann zur Deinterleavingschaltung 69 mit den Umschaltern 70 und 71, denen das ankommende Signal den Strecken 72, 73 und 74 mit unterschiedlichen Verzögerungsdauern zugeführt wird. In der Strecke 72 wird das Signal nicht, in der Strecke 73 um $d_1$ und in der Strecke 74 um $d_2$ verzögert. Am Ausgang 75 erscheint das Signal wieder in seiner ursprünglichen Reihenfolge. Fehlermarkierte Abtastwerte, die nicht in der Paritätsschaltung 68 korrigiert werden konnten, weil innerhalb eines Vergleichsblocks (Fig. 5) mehrere markierte Werte vorlagen, behalten ihre Fehlermarkierung. In der nachfolgenden Interpolationsschaltung 76 werden noch alle mit einer Fehlermarkierung versehenen Datenwörter durch ein Ersatzsignal ersetzt. Vom Interpolationsschaltkreis 76 gelangt das korrigierte Signal zum Digital/Analog-Wandler 77. Die Interpolation kann auch im analogen Bereich durchgeführt werden.

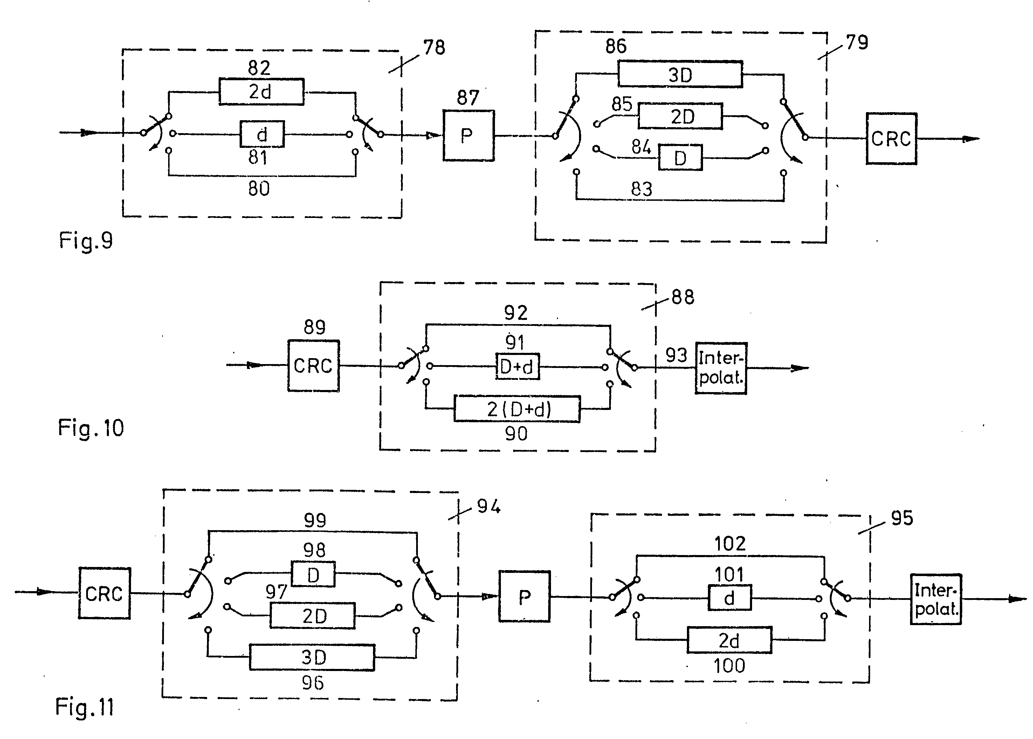

In Fig. 9 ist eine Aufnahmeeinrichtung dargestellt, die zwei Interleavingschaltungen 78 und 79 enthält, die jeweils mit Verzögerungsstrecken arbeiten, die gegeneinander gleiche Verzögerungsabstände aufweisen. Die Strecken 80 bis 82 unterscheiden sich jeweils um die Dauer d, die Strecken 83 bis 86 unterscheiden sich jeweils um die Dauer D. Zwischen den beiden Interleavingschaltkreisen 78 und 79 liegt der Parityschaltkreis 87.

Fig. 10 zeigt eine Deinterleavingschaltung 88, wie sie auf der Wiedergabeseite verwendet werden kann. Das vom CRC-Schaltkreis 89 kommende Signal gelangt in der Deinterleavingschaltung 88 an die Strecken 90, 91 bzw. 92. Die Strecke 90 enthält dabei eine Verzögerung um 2(D + d), die Strecke 91 die Verzögerung D + d und die Strecke 92 keine Verzögerung. Die Anordnung nach Fig. 10 ist komplementär der Anordnung nach Fig. 9 mit dem Unterschied, daß die Deinterleavingschaltung 88 zusammengefaßt die Verzögerungen der Schaltkreise 78 und 79 derart entschachtelt, daß das Signal wieder in der ursprünglichen Reihenfolge am Ausgang 93 der Deinterleavingschaltung 88 anliegt. In der Deinterleavingschaltung 88 wird auf die Auswertung des Paritätswortes, das in der Schaltung 87 den Daten angehängt wurde, verzichtet. Auf eine Verzögerungsstrecke mit der Verzögerungsdauer 3D kann daher in dem Interleavingschaltkreis 88 verzichtet werden. Die Gesamtverzögerung eines Signals beträgt daher für alle Datenwörter 2(D + d). Es hat sich gezeigt, daß eine Auswertung des Paritätswortes in einem Abspielgerät der Konsumelektronik unterbleiben kann, sofern nicht auf eine echte digitale Korrektur z. B. bei einer Überspielung Wert gelegt wird. Das Paritätswort, das auf der Aufnahmeseite den Daten angehängt wurde, wird auf der Wiedergabeseite daher von den Daten abgetrennt und nicht ausgewertet.

Werden sehr hohe Ansprüche an die Wiedergabequalität gestellt, so kann gemäß Fig. 11 auch eine Auswertung des Paritätswortes erfolgen, was aber erfordert, daß entgegen Fig. 10 nicht mit einer Deinterleavingschaltung 88 auszukommen ist, sondern zwei Deinterleavingschaltungen 94 und 95 erforderlich sind, zwischen denen das Paritätswort ausgewertet wird. Die Deinterleavingschaltung 94 enthält dabei komplementär zur Interleavingschaltung 79 die Verzögerungsstrecken 96 bis 99, zwischen denen jeweils gleiche Verzögerungsabstände vorhanden sind. Der Verzögerungsabstand beträgt D. In der zweiten Entschachtelungsanordnung der Wiedergabeseite 95 werden die ankommenden Signale um die Strecken 100, 101, 102 verzögert. Zwischen den Verzögerungsstrecken 100 und 101 sowie 101 und 102 beträgt der Verzögerungsabstand d. Die Gesamtverzögerung der Daten der Aufnahmeseite und Wiedergabeseite beträgt ebenfalls wie in Fig. 10 2(D + d). Die Verzögerung des Paritätswortes um 3D erscheint dabei nicht in der Verzögerung der Signalwörter.

In Fig. 12 ist eine Darstellung der Wirkung von Fehlern bei einer bekannten Einrichtung gemäß Figuren 3 bis 6 mit gleichen Verschachtelungsabständen dargestellt. In Zeile 1 ist ein Datenmuster dargestellt, wie es am Eingang 43 der Deinterleavingschaltung 44 nach Fig. 6 anliegt. Zwei Fehlerstellen X und Y verteilen sich entsprechend der Darstellung in der zweiten Zeile von Fig. 12 nach der Deinterleavingschaltung 44 entsprechend den Mustern der dritten und vierten Zeile der Fig. 12. Treten beide Fehlerstellen X und Y gleichzeitig auf, so erscheint nach der Deinterleavingschaltung ein Datenmuster entsprechend Fig. 12, 5. Zeile. In der 6. Zeile ist dargestellt, wie bei dieser bekannten Einrichtung Fehlerstellen durch Interpolation eliminiert werden können. Die Fehlerstelle 103 kann durch Auswertung des Paritätswortes vollständig beseitigt werden, da in dem Vergleichsblock mit den Abtastworten 3, 4, 5 und dem Paritätswort P3 nur eine Fehlermarkierung auftritt. Hingegen müssen die Fehlerstellen 104, 105 und 106 durch Interpolation beseitigt werden, da hier in jedem Vergleichsblock zwei Fehlermarkierungen vorliegen. Bei den Fehlerstellen 104 und 105 ist dies erschwert, da es sich dabei um Doppelfehlerstellen handelt, zwischen denen kein Stützwert vorhanden ist.

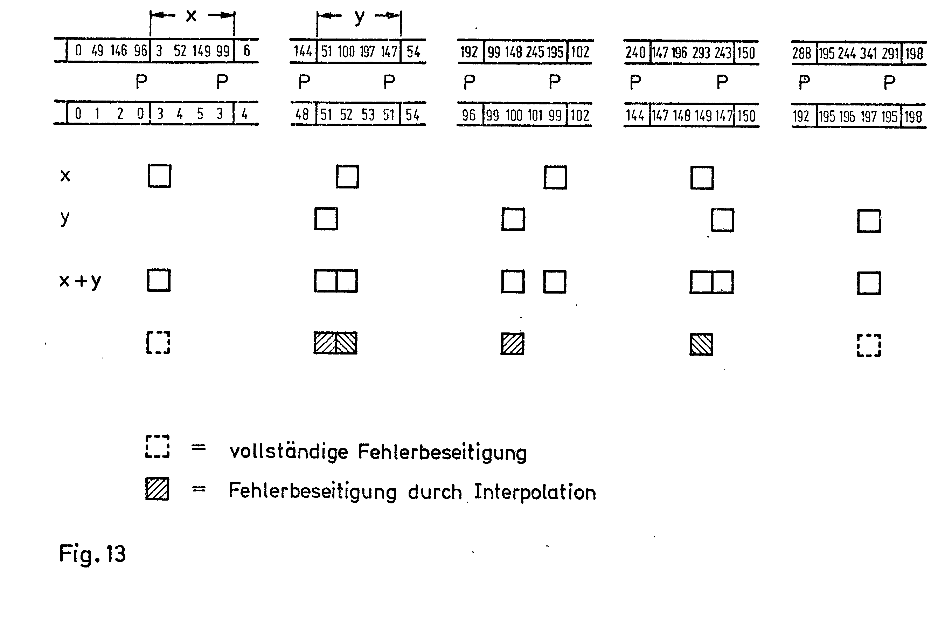

Fig. 13, 1. Zeile zeigt das gleiche Datenmuster wie Fig. 12 erste Zeile. Es zeigt sich, daß eine Fehlerbeseitigung bei Interleavingschaltungen mit ungleichen Verschachtelungsabständen den Vorteil bringt, daß bei einer bestimmten Fehlerverteilung entsprechend Fig. 13, 6. Zeile die Anzahl von Doppelfehlerstellen gegenüber Fig. 12, 6. Zeile verringert ist, so daß die Interpolation erleichtert ist.

Aber auch hier tritt gerade dort, wo eine Korrektur durch Paritätsvergleich nicht möglich ist, immer noch ein Fehler auf der auch für die Korrektur durch Interpolation besonders schlecht geeignet ist, da zwischen den beiden gestörten Worten ein ungestörter Stützwert fehlt.

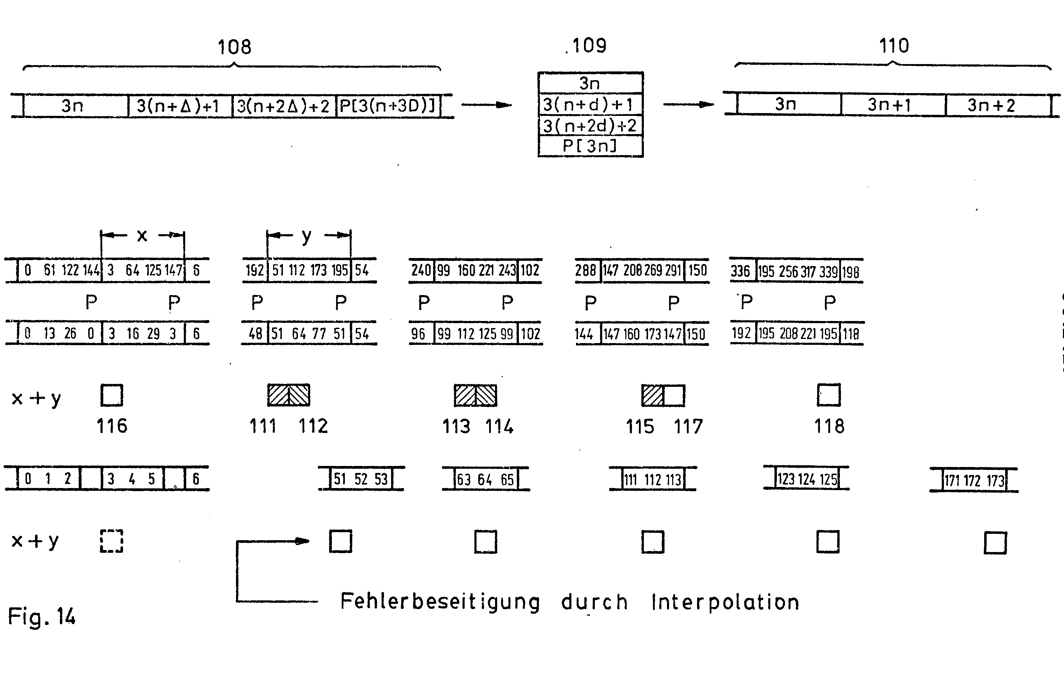

Fig. 14 zeigt eine Darstellung der Wirkung von Fehlern bei einer erfindungsgemäßen Einrichtung gemäß Figuren 9 und 11. Der Block 108 in der ersten Zeile zeigt die Anordnung der Datenwörter, wie sie über den Kanal übertragen werden. Nach der ersten entschachtelung werden diese Daten von dem Paritätswort entsprechend Block 109 befreit. Durch Auswertung des Paritätswortes können Einzelfehler vollständig beseitigt werden. Nach dieser Korrektur gelangen die Datenwörter dann auf eine weitere Deinterleavingschaltung, nach der das endgültige Signal in der Anordnung 110 auf den Digital/Analog-Wandler gegeben werden kann. Fig. 14, zweite Zeile zeigt das Datenmuster am Eingang der ersten Deinterleavingschaltung 94. Fig. 14, 3. Zeile zeigt das Datenmuster am Ausgang der ersten Deinterleavingschaltung 94. In der zweiten und dritten Zeile entspricht jeweils das vierte Datenwort eines Datenblocks dem Paritätswort. Zwei gestörte Datenblöcke X und Y verteilen sich nach der ersten Entschachtelung entsprechend der vierten Zeile. Die Fehlerstelle 116 kann durch Auswertung des Paritätswortes vollständig korrigiert werden. 117 und 118 sind lediglich gestörte Paritätswörter. Die noch verbleibenden Fehlerstellen 111 bis 115 sind entsprechend der fünften Zeile nach der zweiten Entschachtelungsanordnung derart zerstreut, daß jeweils nur noch ein alleinstehendes Datenwort gestört bleibt (6. Zeile). Dadurch ist die nachfolgende Interpolation leicht durchführbar, und eine gute Fehlerverdeckung kann erzielt werden.

Auf diese Weise wird verhindert, daß beim Auftreten von Doppelfehlern die durch Paritätsvergleich nicht korrigierbar sind, gleichzeitig ungünstige Voraussetzungen für eine Interpolation vorliegen. Bei einem Ausführungsbeispiel entsprach die Verzögerungsdauer D der Dauer von 16 Datenblöcken und die Verzögerung d der Dauer von vier Datenblöcken, so daß die Gesamtverzögerung D + d der Dauer von 20 Datenblöcken entsprach.

**Ansprüche**

1. System zur Verarbeitung und Übertragung von PCM-Signalen über einen Kanal, insbesondere von Tonsignalen, die auf einem Magnetband oder einer Platte gespeichert werden, mit Schaltungen zur mehrfachen zyklischen Verschachtelung ankommender Datenwörter und der vor den einzelnen Verschachtelungsschaltungen gebildeten Korrekturwörter auf der Empfangsseite des Kanals und mit Schaltungen zur zyklischen Entschachtelung der Datenwörter und Korrekturwörter auf der Ausgangsseite des Kanals vor den einzelnen Korrekturstufen, so daß die Datenwörter nach der Entschachtelung in der ursprünglichen Reihenfolge vorliegen, dadurch gekennzeichnet, daß auf der Eingangsseite des Kanals vor der Bildung des ersten Korrekturwortes (87) eine zusätzliche Verschachtelung (78) der Datenwörter erfolgt, und daß auf der Ausgangsseite des Kanals nach der letzten Korrektur eine Entschachtelungsschaltung (95) vorgesehen ist, deren Ausgangssignal einer Interpolationsschaltung (20) zugeführt wird.

2. System nach Anspruch 1, dadurch gekennzeichnet, daß auf der Ausgangsseite des Kanals eine Schaltungsanordnung (88) vorhanden ist, die ankommende Datenwörter nur einfach entschachtelt (Fig. 10).

3. System nach Anspruch 1, dadurch gekennzeichnet, daß die zyklische Verschachtelung und die zyklische Entschachtelung der Datenwörter durch unterschiedliche Verzögerung aufeinanderfolgender Datenwörter mittels Verzögerungsstrecken (56, 57 ; 73, 74 ; 81, 82 ; 84-86 ; 90, 91 ; 96-98 ; 100, 101) erfolgt.

4. System nach Anspruch 3, dadurch gekennzeichnet, daß die einzelnen Verschachtelungen so zusammengesetzt sind, daß sich eine möglichst große Gesamtverzögerung ergibt.

5. System nach Anspruch 1, dadurch gekennzeichnet, daß bei Vorliegen von zwei Verschachtelungs- bzw. Entschachtelungseinrichtungen unterschiedliche Zyklusdauern vorgesehen sind.

6. System nach Anspruch 1, dadurch gekennzeichnet, daß jeweils drei verschachtelte Datenwörter und ein angehängtes Paritätswort in einem Block übertragen werden.

7. System nach Anspruch 3 und 5, dadurch gekennzeichnet, daß die Differenzen der Verzögerungsdauern den Verzögerungsstrecken (81, 82) der ersten Verschachtelungseinrichtung (78) gleich sind, Differenzen der Verzögerungsdauer zwischen den Verzögerungsstrecken (84-86) der zweiten Verzögerungseinrichtung (79) gleich sind, wobei die Differenzen der Verzögerung in der ersten Verschachtelungseinrichtung (78) nicht gleich den Differenzen der Verzögerung in der zweiten Verschachtelungseinrichtung (79) sind.

8. System nach Anspruch 3 und 5, dadurch gekennzeichnet, daß die Differenzen der Verzögerungsdauer zwischen den Verzögerungsstrecken (96-98) der ersten Entschachtelungseinrichtung (94) gleich sind, die Differenzen der Verzögerungsdauer zwischen den Verzögerungsstrecken (100, 101) der zweiten Entschachtelungseinrichtung (95) gleich sind, wobei die Differenzen der Verzögerung in der ersten Entschachtelungseinrichtung (94) nicht gleich den Differenzen der Verzögerung der zweiten Entschachtelungseinrichtung (95) sind.

9. System nach Anspruch 3 und 5, dadurch gekennzeichnet, daß die Differenzen der Verzögerungsdauer zwischen den Verzögerungsstrecken (81, 82) der ersten Verschachtelungseinrichtung (78) nicht gleich sind, die Differenzen der Verzögerungsdauer zwischen den Verzögerungsstrecken (84-86) der zweiten Verzögerungseinrichtung (79) nicht gleich sind, wobei die Differenzen der Verzögerung in der ersten Verschachtelungseinrichtung (78) nicht gleich den Differenzen der Verzögerung in der zweiten Verschachtelungseinrichtung (79) sind.

10. System nach Anspruch 3 und 5, dadurch gekennzeichnet, daß die Differenzen der Verzögerungsdauer zwischen den Verzögerungsstrecken (96-98) der ersten Entschachtelungseinrichtung (94) nicht gleich sind, die Differenzen der Verzögerungsdauer zwischen den Verzögerungsstrecken (100, 101) der zweiten Entschachtelungseinrichtung (95) nicht gleich sind, wobei die Differenzen der Verzögerung in der ersten Entschachtelungseinrichtung (94) nicht gleich den Differenzen der Verzögerung der zweiten Entschachtelungseinrichtung (95) sind.

11. System nach Anspruch 7, dadurch gekennzeichnet, daß die Differenzen der Verzögerungsdauer zwischen den Verzögerungsstrecken (84-86) der zweiten Verschachtelungseinrichtung (79) gleich oder etwa gleich dem fünffachen der Differenzen der Verzögerungsdauer zwischen den Verzögerungsstrecken (81, 82) der ersten Verschachtelungseinrichtung (78) sind.

12. System nach Anspruch 8, dadurch gekennzeichnet, daß die Differenzen der Verzögerung zwischen den Verzögerungsstrecken (96-98) der ersten Entschachtelungseinrichtung gleich oder etwa gleich dem fünffachen der Differenzen der Verzögerung zwischen den Verzögerungsstrecken (100, 101) der zweiten Entschachtelungseinrichtung (95) sind.

13. System nach Anspruch 3 und 5, dadurch gekennzeichnet, daß die Differenzen der Verzögerung zwischen den Verzögerungsstrecken in der ersten (81, 82) und der zweiten (84-86) Verschachtelungseinrichtung übereinstimmen.

14. System nach Anspruch 3 und 5, dadurch gekennzeichnet, daß die Differenzen der Verzögerung zwischen den Verzögerungsstrecken in der ersten (96-98) und der zweiten (100, 101) Entschachtelungseinrichtung übereinstimmen.

15. System nach Anspruch 3, dadurch gekennzeichnet, daß für die Verzögerungsstrecken ein RAM (random access memory)-Schaltkreis verwendet wird.

16. System nach Anspruch 1, dadurch gekennzeichnet, daß den verschachtelten Datenwörtern blockweise ein CRC-Datenwort und ein Synchronisationswort angehängt wird.

17. System nach Anspruch 6, dadurch gekennzeichnet, daß jedes Datenwort aus einem Abtastwertepaar bzw. Abtastwertequartett besteht.

18. System nach Anspruch 6, dadurch gekennzeichnet, daß nach der ersten Verschachtelung ein Paritätswort aus einer modulo-2-Addition der einzelnen Datenbits einer bestimmten Anzahl von Datenwörtern, die gleich der Anzahl der Datenwörter eines Blockes ist, gebidet wird.

19. System nach Anspruch 6 und einem der Ansprüche 7, 8, 11, 12 oder 13, dadurch gekennzeichnet, daß die Differenz der Verzögerung zwischen den Verzögerungsstrecken der ersten Verschachtelungseinrichtung (78) sowie der zweiten Entschachtelungseinrichtung (95) der Dauer von 4 Blöcken, die Verzögerungsdifferenz zwischen den Verzögerungsstrecken der zweiten Verschachtelungseinrichtung (79) sowie der ersten Entschachtelungseinrichtung (94) der Dauer von 16 Blöcken entspricht.

20. System nach Anspruch 19, dadurch gekennzeichnet, daß die Gesamtverzögerungsdifferenz zwischen den Verzögerungsstrecken der Verschachtelungseinrichtungen (78, 79) sowie der Entschachtelungseinrichtung (88, 94, 95) der Dauer von 20 Blöcken entspricht.

21. System nach Anspruch 5, dadurch gekennzeichnet, daß den zweiten Entschachtungseinrichtungen (69, 95, 88) ein Digital/Analog-Wandler nachgeschaltet ist, und die Interpolation hinter dem Digital/Analog-Wandler erfolgt.

**Claims**

1. System for the processing and transmission of PCM signals over a channel, especially of sound signals which have been stored on a magnetic band or a plate,/having circuits for the manifold cyclic interleaving at the receiving side of the channel of incoming data words and of the correction words formed in front of the individual interleaving circuits and having circuits for the cyclic de-interleaving of the data words and correction words at the output side of the channel in front of the individual correction stages, so that the data words appear after the de-interleaving in the original sequence, characterized in that on the input side of the channel and additional interleaving (78) takes place in front of the formation of the first correction word (87) and that on the output side of the channel after the last correction a de-interleaving circuit (95) is provided, the output signal from which is conducted to an interpolation circuit (20).

2. System according to claim 1, characterized in that at the output side of the channel, a circuit arrangement (88) is provided which de-interleaves the incident data words only singly (Fig. 10).

3. System according to claim 1, characterized in that the cyclic interleaving and the cyclic de-interleaving of the data words ensues as a result of different delay of successive data words, through the agency of delay lines (56, 57 ; 73, 74 ; 81, 82 ; 84-86 ; 90, 91 ; 96-98 ; 100, 101).

4. System according to claim 3, characterized in that the individual interleavings are so interrelated that the greatest possible overall delay occurs.

5. System according to claim 1, characterized in that in the case of two interleaving or de-interleaving arrangements, different cycle durations are provided.

6. System according to claim 1, characterized in that at times three interleaved data words and an appended parity word are transmitted in a block.

7. System according to claims 3 and 5, characterized in that the differences of the delay times of the delay lines (81, 82) of the first interleaving arrangement (78) are equal, the differences of the delay time between the delay lines (84-86) of the second delay arrangement (79) are equal, in connection with which the differences of the delay in the first interleaving arrangement (78) are not equal to the differences of the delay in the second interleaving arrangement (79).

8. System according to claim 3 and 5, characterized in that the differences of the delay times between the delay lines (96-98) of the first de-interleaving arrangement (94) are equal, the differences of the delay time between the delay lines (100, 101) of the second de-interleaving arrangement (95) are equal, in connection with which the differences of the delay in the first de-interleaving arrangement (94) are not equal to the differences of the delay in the second de-interleaving arrangement (95).

9. System according to claim 3 and 5, characterized in that the differences of the delay time between the delay lines (81, 82) of the first interleaving arrangement (78) are not equal, the differences of the delay times between the delay lines (84-86) of the second delay arrangement (79) are not equal, in connection with which the differences of the delay in the first interleaving arrangement (78) are not equal to the differences of the delay in the second interleaving arrangement (79).

10. System according to claim 3 and 5, characterized in that the differences of the delay time between the delay lines (96-98) of the first de-interleaving arrangement (94) are not equal, the differences of the delay time between the delay lines (100, 101) of the second de-interleaving arrangement (95) are not equal, in connection with which the differences of the delay in the first de-interleaving arrangement (94) are not equal to the differences of the delay of the second de-interleaving arrangement (95)

11. System according to claim 7, characterized in that the differences in the delay time between the delay lines (84-86) of the second interleaving arrangement (79) are equal or substantially equal to the fifth multiple of the difference of the delay time between the delay lines (81, 82) of the first interleaving arrangement (78).

12. System according to claim 8, characterized in that the differences of the delay between the delay lines (96-98) of the first de-interleaving arrangement are equal or substantially equal to the fifth multiple of the differences of the delay between the delay lines (100, 101) of the second de-interleaving arrangement (95).

13. System according to claim 3 and 5, characterized in that the differences of the delay between the delay lines in the first (81, 82) and the second (84-86) interleaving arrangement correspond to one another.

14. System according to claim 3 and 5, characterized in that the differences of the delay between the delay lines in the first (96-98) and the second (100, 101) de-interleaving arrangement correspond to one another.

15. System according to claim 3, characterized in that a RAM (random access memory)-switching circuit is used for the delay lines.

16. System according to claim 1, characterized in that a CRC-data word and a synchronisation word is appended block-wise to the interleaved data words.

17. System according to claim 6, characterized in that each data word consists of a pair of sample values or a quartet of sample values.

18. System according to claim 6, characterized in that after the first interleaving, a parity word is formed from the modulo-2-addition of the individual data bits of a predetermined number of data words, which number is equal to the number of data words in a block.

19. System according to claim 6 and one of the claims 7, 8, 11, 12 or 13, characterized in that the difference of the delay between the delay lines of the first interleaving arrangement (78) as well as of the second de-interleaving arrangement (95) corresponds to the duration of 4 blocks, and the delay difference between the delay lines of the second interleaving arrangement (79) as well as of the first de-interleaving arrangement (94) corresponds to the duration of 16 blocks.

20. System according to claim 19, characterized in that the collective delay difference between the delay lines of the interleaving arrangements (78, 79) as well as of the de-interleaving arrangement (88, 94, 95) corresponds to the duration of 20 blocks.

21. System according to claim 5, characterized in that a digital/analogue-converter is connected after the second de-interleaving arrangements (69, 95, 98), and the interpolation follows behind the digital/analogue-converter.

**Revendications**

1. Système pour le traitement et la transmission de signaux MIC sur une voie, et en particulier de signaux audio enregistrés sur une bande magnétique ou un disque, avec des circuits d'entrelacement cycliques multiples de mots de données entrants et des mots de correction formés en amont des divers circuits d'entrelacement du côté réception de la voie, et avec des circuits de restitution cyclique des mots de données et des mots de correction du côté sortie de la voie, en amont des divers étages de correction, de sorte que les mots de données apparaissent après restitution dans la séquence initiale, ledit système étant caractérisé par un entrelacement supplémentaire (78) des mots de données du côté entrée de la voie, avant la formation du premier mot de correction (87) ; et un circuit de restitution (95) prévu du côté sortie de la voie, après la dernière correction, et dont le signal de sortie est transmis à un circuit d'interpolation (20).

2. Système selon revendication 1, caractérisé par un circuit (88) situé du côté sortie de la voie et ne produisant qu'une restitution simple des mots de données entrants (fig. 10).

3. Système selon revendication 1, caractérisé en ce que l'entrelacement cyclique et la restitution cyclique des mots de données s'effectuent par un retard différent des mots de données successifs, à l'aide de lignes de retard (56, 57 ; 73, 74 ; 81, 82 ; 84-86 ; 90, 91 ; 96-98 ; 100, 101).

4. Système selon revendication 3, caractérisé en ce que les divers entrelacements sont composés de façon à donner un retard total maximal.

5. Système selon revendication 1, caractérisé en ce que des durées de cycle différentes sont prévues en présence de deux dispositifs d'entrelacement ou restitution.

6. Système selon revendication 1, caractérisé par la transmission dans chaque bloc de trois mots de données entrelacés et d'un mot de parité ajouté.

7. Système selon revendications 3 et 5, caractérisé en ce que les différences des retards des lignes de retard (81, 82) du premier dispositif d'entrelacement (78) sont égales et les différences de retard des lignes de retard (84-86) du second dispositif d'entrelacement (79) sont égales, les différences de retard du premier dispositif d'entrelacement (78) n'étant pas égales à celles du second dispositif d'entrelacement (79).

8. Système selon revendications 3 et 5, caractérisé en ce que les différences de retard des lignes de retard (96, 98) du premier dispositif de restitution (94) sont égales, et les différences de retard des lignes de retard (100, 101) du second dispositif de restitution (95) sont égales, les différences de retard du premier dispositif de restitution (94) n'étant pas égales à celles du second dispositif de restitution (95).

9. Système selon revendications 3 et 5, caractérisé en ce que les différences de retard des lignes de retard (81, 82) du premier dispositif d'entrelacement (78) ne sont pas égales, et les différences de retard des lignes de retard (84-86) du second dispositif d'entrelacement (79) ne sont pas égales, les différences de retard du premier dispositif d'entrelacement (78) n'étant pas égales à celles du second dispositif d'entrelacement (79).

10. Système selon revendications 3 et 5, caractérisé en ce que les différences de retard des lignes de retard (96-98) du premier dispositif de restitution (94) ne sont pas égales, et les différences de retard des lignes de retard (100, 101) du second dispositif de restitution (95) ne sont pas égales, les différences de retard du premier dispositif de restitution (94) n'étant pas égales à celles du second dispositif de restitution (95).

11. Système selon revendication 7, caractérisé en ce que les différences de retard des lignes de retard (84-86) du second dispositif d'entrelacement (79) sont égales ou sensiblement égales au quintuple des différences de retard des lignes de retard (81, 82) du premier dispositif d'entrelacement (78).

12. Système selon revendication 8, caractérisé en ce que les différences de retard des lignes de retard (96-98) du premier dispositif de restitution sont égales ou sensiblement égales au quintuple des différences de retard des lignes de retard (100, 101) du second dispositif de restitution (95).

13. Système selon revendications 3 et 5, caractérisé en ce que les différences de retard des lignes de retard du premier (81, 82) et du second (84-86) dispositif d'entrelacement coïncident.

14. Système selon revendication 3 et 5, caractérisé en ce que les différences de retard des lignes de retard du premier (96-98) et du second (100, 101) dispositif de restitution coïncident.

15. Système selon revendication 3, caractérisé par l'emploi d'un circuit RAM (mémoire vive) pour les lignes de retard.

16. Système selon revendication 1, caractérisé en ce qu'un mot de données CRC et un mot de synchronisation sont ajoutés aux mots de données entrelacés.

17. Système selon revendication 6, caractérisé en ce que chaque mot de données est constitué par une paire de valeurs échantillonnées ou un quartet de valeurs échantillonnées.

18. Système selon revendication 6, caractérisé par la formation, après le premier entrelacement, d'un mot de parité à l'aide d'une addition modulo 2 des divers bits de données d'un nombre déterminé de mots de données, égal à celui des mots de données d'un bloc.

19. Système selon revendication 6 et une quelconque des revendications 7, 8, 11, 12 ou 13, caractérisé en ce que la différence de retard des lignes de retard du premier dispositif d'entrelacement (78) et du second dispositif de restitution (95) est égale à la durée de quatre blocs, et la différence de retard des lignes de retard du second dispositif d'entrelacement (79) et du premier dispositif de restitution (94) est égale à la durée de 16 blocs.

20. Système selon revendication 19, caractérisé en ce que la différence totale de retard des lignes de retard des dispositifs d'entrelacement (78, 79) et des dispositifs de restitution (88, 94, 95) est égale à la durée de 20 blocs.

21. Système selon revendication 5, caractérisé en ce qu'un convertisseur numérique-analogique est monté en aval des seconds dispositifs de restitution (69, 95, 88) et l'interpolation s'effectue en aval du convertisseur numérique-analogique.

Fig. 1

Fig. 2

Fig. 3

Fig. 4

Fig. 5

Fig. 6

Fig. 7

Fig. 8

.2

Fig.9

Fig.10

Fig.11

| 0 | 49 | 98 | 144 | 3 | 52 | 101 | 147 | 6 | | 192 | 51 | 100 | 149 | 195 | 54 | | 240 | 99 | 148 | 197 | 243 | 102 | | 288 | 147 | 196 | 245 | 291 | 150 | | 336 | 195 | 244 | 293 | 339 | 198 |

|←— x —→| |←— y —→|

P P    P P    P P    P P    P P

| 0 | 1 | 2 | 0 | 3 | 4 | 5 | 3 | 6 | | 48 | 51 | 52 | 53 | 51 | 54 | | 96 | 99 | 100 | 101 | 99 | 102 | | 144 | 147 | 148 | 149 | 147 | 150 | | 192 | 195 | 196 | 197 | 195 | 198 |

x

y

x+y

103    104    105    106

⊡ = vollständige Fehlerbeseitigung

▨ = Fehlerbeseitigung durch Interpolation

Fig. 12

[ ] = vollständige Fehlerbeseitigung

▨ = Fehlerbeseitigung durch Interpolation

Fig. 13

Fig. 14

Fehlerbeseitigung durch Interpolation